# EUROPEAN PATENT APPLICATION

(11) **EP 3 503 184 A1**
(43) Date of publication of application: **26.06.2019**
(21) Application number: 18211926.3
(22) Date of filing: 12.12.2018
(51) Int. Cl.: H01L 27/02, H02H 9/04

(54) **DEVICE AND METHOD FOR ELECTROSTATIC DISCHARGE (ESD) PROTECTION**

(30) Priority: 21.12.2017 US 201715851534
(71) Applicant: NXP B.V., 5656 AG Eindhoven (NL)
(72) Inventor: Lai, Da-Wei, Redhill, Surrey RH1 1QZ (GB); Tseng, Wei-Jhih, Redhill, Surrey RH1 1QZ (GB)
(74) Representative: Miles, John Richard

(57) **Abstract**

Embodiments of an ESD protection device and a method for operating an ESD protection device are described. In one embodiment, an ESD protection device includes a first bipolar device connected to a first node, a second bipolar device connected to the first bipolar device and to a second node, a metal-oxide-semiconductor (MOS) device connected to the first and second nodes and to the first and second bipolar devices and configured to shunt current in response to an ESD pulse received between the first and second nodes, and a diode device connected to the first node, to a third node, to the first and second bipolar devices, and to the MOS device. Other embodiments are also described.

## Description

Embodiments of the invention relate generally to electronic hardware and methods for operating electronic hardware, and, more particularly, to electrostatic discharge (ESD) protection devices and methods for providing ESD protection.

Electrostatic discharge is a sudden flow of electricity that can be caused by a buildup of static electricity. An ESD protection device can be used to shunt ESD current to prevent thermal damage in a device. For example, an ESD protection device can be integrated into an electronic device, such as an integrated circuit (IC) chip, to provide a low impedance channel to prevent thermal damage to components of the electronic device. Operating characteristics of an ESD protection device (e.g., fail-current density, which is ESD current capability per substrate area, or ESD leakage current level) can affect the performance of the ESD protection device.

### SUMMARY

Embodiments of an ESD protection device and a method for operating an ESD protection device are described. In one embodiment, an ESD protection device includes a first bipolar device connected to a first node, a second bipolar device connected to the first bipolar device and to a second node, a metal-oxide-semiconductor (MOS) device connected to the first and second nodes and to the first and second bipolar devices and configured to shunt current in response to an ESD pulse received between the first and second nodes, and a diode device connected to the first node, to a third node, to the first and second bipolar devices, and to the MOS device. Other embodiments are also described.

In one embodiment, the first and second bipolar devices are of different types.

In one embodiment, the first bipolar device includes a PNP bipolar transistor, the second bipolar device includes an NPN bipolar transistor, and the MOS device includes an NMOS transistor.

In one embodiment, the NMOS transistor includes a gate terminal and a source terminal that are connected to the NPN bipolar transistor and to the second node, a drain terminal that is connected to an emitter and a base of the PNP bipolar transistor, to the diode device, and to the first node, and a body that is connected to the PNP bipolar transistor and to the NPN bipolar transistor.

In one embodiment, the gate terminal and the source terminal of the NMOS transistor are connected to an emitter of the NPN bipolar transistor.

In one embodiment, the base of the PNP bipolar transistor is connected to a collector of the NPN bipolar transistor.

In one embodiment, the body of the NMOS transistor is connected to a collector of the PNP bipolar transistor and to a base of the NPN bipolar transistor.

In one embodiment, the ESD protection device further includes a resistor device connected between the NMOS transistor and the second node, where the body of the NMOS transistor is connected to the resistor device.

In one embodiment, an anode of the diode device is connected to the first node, and a cathode of the diode device is connected to the third node.

In one embodiment, the MOS device includes a gate terminal and a source terminal connected to the second node and a body connected to the first and second bipolar devices.

In one embodiment, the MOS device and at least one of the first and second bipolar devices act as a silicon controlled rectifier (SCR) in response to the ESD pulse.

In one embodiment, an ESD protection device includes a first bipolar device connected to a first node, a second bipolar device connected to the first bipolar device and to a second node, where the first and second bipolar devices include a PNP bipolar transistor and an NPN bipolar transistor, a MOS device connected to the first and second nodes and to the first and second bipolar devices and configured to shunt current in response to an ESD pulse received between the first and second nodes, and a diode device connected to the first node, to a third node, to the first and second bipolar devices, and to the MOS device.

In one embodiment, the first bipolar device includes the PNP bipolar transistor, and the second bipolar device includes the NPN bipolar transistor.

In one embodiment, a base of the PNP bipolar transistor is connected to a collector of the NPN bipolar transistor, and a base of the NPN bipolar transistor is connected to a collector of the PNP bipolar transistor.

In one embodiment, the MOS device includes an NMOS transistor, and the NMOS transistor includes a gate terminal and a source terminal that are connected to an emitter of the NPN bipolar transistor and to the second node, a drain terminal that is connected to an emitter and the base of the PNP bipolar transistor, to the collector of the NPN bipolar transistor, to the diode device, and to the first node, and a body that is connected to the collector of the PNP bipolar transistor and to the base of the NPN bipolar transistor.

In one embodiment, the ESD protection device further includes a resistor device connected between the NMOS transistor and the second node, where the body of the NMOS transistor is connected to the resistor device.

In one embodiment, an anode of the diode device is connected to the first node, to the emitter of the PNP bipolar transistor, to the drain terminal of the NMOS transistor, and to the collector of the NPN transistor, and a cathode of the diode device is connected to the third node.

In one embodiment, the NMOS transistor and at least one of the PNP bipolar transistor and the NPN bipolar transistor act as a SCR in response to the ESD pulse.

In one embodiment, a method for operating an ESD protection device involves receiving an ESD pulse at the ESD protection device, in response to the ESD pulse, activating a diode device of the ESD protection device, and in response to activating the diode device, conducting an ESD current from the ESD pulse using a SCR.

In one embodiment, a MOS device and a bipolar device of the ESD protection device act as the SCR in response to the ESD pulse.

Other aspects and advantages of embodiments of the present invention will become apparent from the following detailed description, taken in conjunction with the accompanying drawings, depicted by way of example of the principles of the invention.

### BRIEF DESCRIPTION OF THE DRAWINGS

Fig. 1 is a schematic block diagram of an electronic device in accordance with an embodiment of the invention.
Fig. 2 depicts a top layout view of an ESD protection device in accordance with an embodiment of the invention.
Fig. 3 depicts a cross sectional view of the ESD protection device depicted in Fig. 2.
Fig. 4 is a process flow diagram that illustrates a method for operating an ESD protection device in accordance with an embodiment of the invention.

Throughout the description, similar reference numbers may be used to identify similar elements.

### DETAILED DESCRIPTION

It will be readily understood that the components of the embodiments as generally described herein and illustrated in the appended figures could be arranged and designed in a wide variety of different configurations. Thus, the following detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment. Rather, language referring to the features and advantages is understood to mean that a specific feature, advantage, or characteristic described in connection with an embodiment is included in at least one embodiment. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment. Thus, the phrases "in one embodiment," "in an embodiment," and similar language throughout this specification may, but do not necessarily, all refer to the same embodiment.

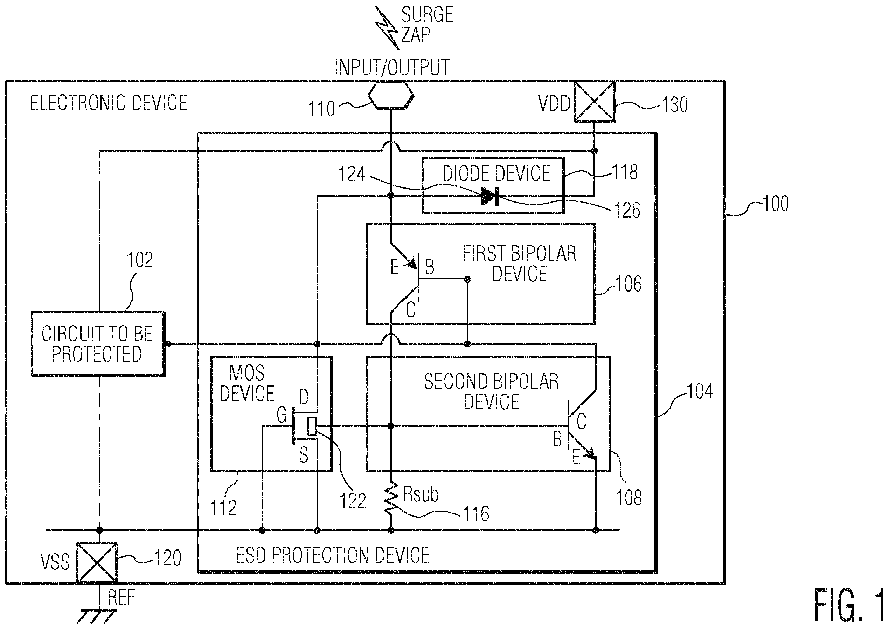

Fig. 1 is a schematic block diagram of an electronic device 100 in accordance with an embodiment of the invention. In the embodiment depicted in Fig. 1, the electronic device includes a circuit to be protected 102 (also referred to as the "core circuit") and an ESD protection device 104 that is used to protect the core circuit during an ESD event, which may be an ESD test or an actual ESD strike.

The electronic device 100 can be used in various applications, such as automotive applications, communications applications, industrial applications, medical applications, computer applications, and/or consumer or appliance applications. In some embodiments, the electronic device is an IC device. For example, the electronic device can be fabricated in a substrate, such as a semiconductor wafer and/or, included on a printed circuit board (PCB). In some embodiments, the electronic device is included in a computing device, such as a smartphone, a tablet computer, a laptop, etc. For example, the electronic device may be included in a Near Field Communications (NFC) capable computing device. Although the electronic device is shown in Fig. 1 as including the core circuit 102 and the ESD protection device 104, in other embodiments, the electronic device may include additional circuit elements. For example, the electronic device may include a control circuit that is located in a low voltage domain and used to control the core circuit that is located in a high voltage domain.

The core circuit 102 typically includes one or more internal circuit components, such as transistors, capacitors, or diodes, which are susceptible to ESD strikes. Examples of the core circuit include, but are not limited to, microcontrollers, transceivers, and switching circuits, which can be used for, for example, in vehicle control or communications, identification, wireless communications, and/or lighting control. The core circuit is protected by the ESD protection device 104 in case of an ESD event, such as an ESD pulse received between a first node 110, which is also referred to as an Input/Output node, and a second node 120. The core circuit and the ESD protection device are both connected to a third node 130 and to the second node. The second and third nodes are coupled to different voltages. In some embodiments, the third node 130 is connected to a positive voltage, "V_{DD}," and the second node 120 is connected to a voltage, "Vss," that is lower than the voltage, VDD, at the third node 130 or vise versa. In an embodiment, the electronic device is an IC device and the first, second, and third nodes are electrical terminals of the IC device, such as electrical contact pads or electrical contact pins. At least one of the first, second and third nodes may be located at least partially within of the packaging of the ESD protection device.

The ESD protection device 104 protects the core circuit 102 during an ESD event, such as an ESD pulse received between the first and second nodes 110, 120. The ESD protection device can be used to protect a power supply domain of the electronic device 100. For example, the ESD protection device may be connected to a power supply rail of the electronic device and may shunt ESD current to protect the core circuit in response to an ESD pulse. The ESD protection device can be implemented by suitable semiconductor devices, for example, on the same substrate as the core circuit. In the embodiment depicted in Fig. 1, the ESD protection device includes a first bipolar device 106 connected to the first node 110, a second bipolar device 108 connected to the first bipolar device and to the second node 120, a metal-oxide-semiconductor (MOS) device 112, and a diode device 118 connected to the first node, to the third node, to the first and second bipolar devices, and to the MOS device, and an optional resistor device 116 that is connected between the second bipolar device and the second node 120. In the embodiment depicted in Fig. 1, the MOS device is connected to the first and second nodes and to the first and second bipolar devices and configured to shunt current in response to an ESD pulse received between the first and second nodes. In some embodiments, the first and second bipolar transistors are of different types. For example, one of the first and second bipolar transistors is a PNP bipolar transistor while the other one of the first and second bipolar transistors is an NPN bipolar transistor. In the embodiment depicted in Fig. 1, an anode 124 of the diode device is connected to the first node and a cathode 126 of the diode device is connected to the third node. Although the first bipolar device, the second bipolar device, the MOS device, and the diode device are shown in Fig. 1 as being connected in a certain manner, in other embodiments, the first bipolar device, the second bipolar device, the MOS device, and the diode device are connected differently from the embodiment depicted in Fig. 1. For example, the second bipolar device may be directly connected to the second node while the MOS device may be connected to the second node through a different electrical connection.

In the embodiment depicted in Fig. 1, the MOS device 112 and the first and second bipolar transistors 106, 108 acts as a silicon controlled rectifier (SCR) in response to an ESD pulse received between the first and second nodes 110, 120. In an example operation of the ESD protection device 104, during an ESD event (e.g., an ESD pulse received between the first node 110 and the second node 120), if the ESD voltage exceeds the trigger voltage of the ESD protection device, then the diode device 118 is activated, which is then forward biased. Once the diode device is forward biased, trigger current is injected into the MOS device, which activates the SCR formed by the MOS device and by the first and second bipolar devices, and creates a trigger voltage event. Thus, once the trigger voltage is reached for the ESD protection circuit, the SCR can enter a conducting state (i.e., "on" state) and current is then shunted through the ESD protection circuit.

Compared to a capacitive ESD rail-clamp and a typical ESD protection device that utilizes a large diode (e.g., a 500µm wide diode), the ESD protection device 104 depicted in Fig. 1 can provide ESD protection with a higher fail-current density, a lower leakage current, and a smaller substrate size, for various applications across a wide range of voltages, including 1.8V applications, 3.3V applications, and 5V applications. Consequently, the ESD protection device depicted in Fig. 1 can be used in devices with limited substrate sizes, such as system on a chip (SoC) devices. For example, the size (i.e., physical dimensions) of a capacitive ESD rail-clamp may be too big for ESD protection in a SoC device. Compared to a capacitive ESD rail-clamp, the ESD protection device depicted in Fig. 1 requires less substrate area while still providing fast reacting ESD protection and a lower leakage current. Consequently, the ESD current capability per substrate area of the ESD protection device depicted in Fig. 1 is higher than the ESD current capability per substrate area of a typical capacitive trigger ESD rail-clamp. In addition, a capacitive ESD rail-clamp typically needs to be re-designed for applications with different voltages. For example, different DC-triggered control circuits and different types of BigFETs are needed for 1.8V applications, for 3.3V applications, and for 5V applications. Compared to a capacitive ESD rail-clamp, the ESD protection device depicted in Fig. 1 can be used for various ESD protection applications across a wide range of voltages, including 1.8V applications, 3.3V applications, and 5V applications, without re-designing the components of the ESD protection device. Compared to a typical ESD protection device that utilizes a large diode (e.g., a 500µm wide diode), the ESD protection device depicted in Fig. 1 can be implemented using a smaller diode device 118 with a smaller dimension (e.g., a diode having a width of a approximately 60µm). Furthermore, the ESD protection device depicted in Fig. 1 can be manufactured using common CMOS process, which can reduce the cost of manufacturing the ESD protection device.

As illustrated in Fig. 1, in an embodiment, the first bipolar device 106 is implemented as a PNP bipolar transistor, the second bipolar device 108 is implemented as an NPN bipolar transistor, and the MOS device 112 is implemented as an NMOS transistor. The gate terminal (G) and the source terminal (S) of the NMOS transistor are connected to the emitter (E) of the NPN bipolar transistor and to the second node 120, which is connected to a reference voltage (e.g., ground). The drain terminal (D) of the NMOS transistor is connected to the emitter (E) of the PNP bipolar transistor, to the emitter (E) and the base (B) of the PNP bipolar transistor, to the collector (C) of the NPN bipolar transistor, and to the first node 110, which is connected to a positive voltage that is higher than the reference voltage at the second node. The NMOS transistor also includes a floating body 122 that is connected to the collector (C) of the PNP bipolar transistor and to the base (B) of the NPN bipolar transistor. The anode 124 of the diode device 118 is connected to the first node, to the emitter (E) of the PNP bipolar transistor, to the drain terminal (D) of the NMOS transistor, and to the collector (C) of the NPN transistor. In some embodiments, the PNP bipolar transistor, the NPN bipolar transistor, and the NMOS transistor are fabricated on a common substrate layer, such as a P-doped substrate layer. However, in other embodiments, the ESD protection device can be implemented differently with more or less components.

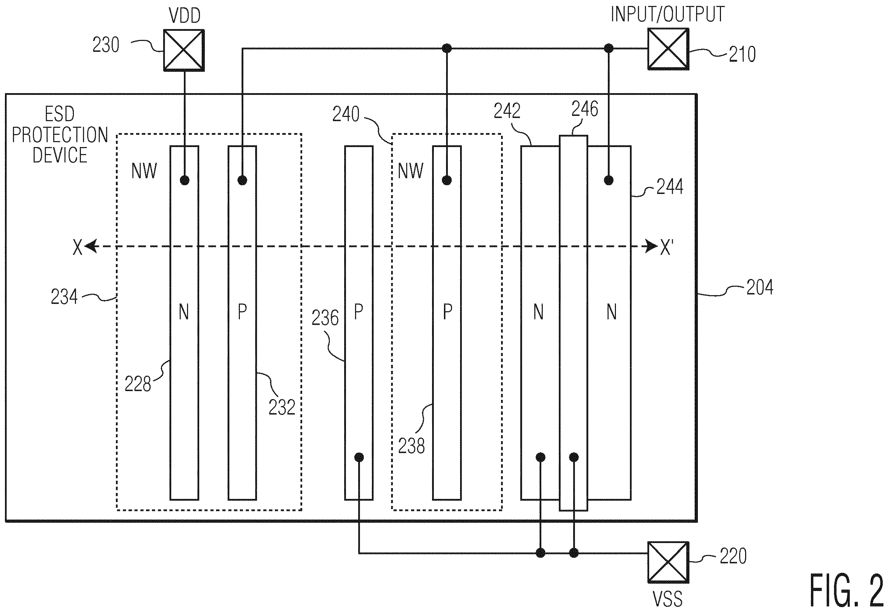

Fig. 2 depicts a top layout view of an ESD protection device 204 in accordance with an embodiment of the invention. In the top layout view depicted in Fig. 2, the ESD protection device 204 includes an N-doped region 228 and a P-doped region 232 that is located on an N-doped well (NW) 234, a P-doped region 236, a P-doped region 238 that is located on an N-doped well (NW) 240, and N-doped regions 242, 244 that are connected to a polysilicon (poly) region 246. The N-doped region 228 is connected to a VDD pin 230. The P-doped regions 232, 238 and the N-doped region 244 are connected to an Input/Output (I/O) pin 210. The P-doped region 236, the N-doped region 242, and the poly region 246 are connected to a VSS pin 220, which is connected to a voltage that is lower than the voltage applied to the VDD pin. The ESD protection device 204 depicted in Fig. 2 is a possible implementation of the ESD protection device 104 depicted in Fig. 1. However, the ESD protection device depicted in Fig. 1 can be implemented differently from the layout depicted in Fig. 2. For example, although the ESD protection device is shown in Fig. 2 as including a certain number of N-doped regions and P-doped regions, in other embodiments, the ESD protection device may include more N-doped regions and/or more P-doped regions and/or less N-doped regions and/or less P-doped regions.

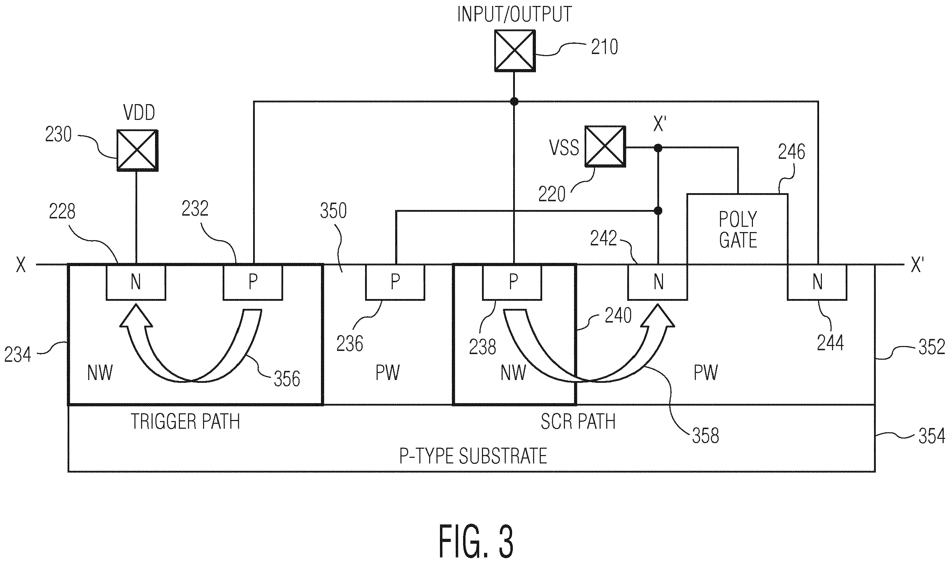

Fig. 3 depicts a cross sectional view of the ESD protection device 204 depicted in Fig. 2. In the cross sectional view (e.g., at the location indicated in Fig. 2 by the dashed arrow from X to X'), the N-doped region 228 and the P-doped region 232 are at least partially formed on top of and in contact with the N-doped well (NW) 234, the P-doped region 236 is at least partially formed on top of and in contact with a P-doped well (PW) 350, the P-doped region 238 is at least partially formed on top of and in contact with the N-doped well (NW) 240, and the N-doped regions 242, 244 are at least partially formed on top of and in contact with a P-doped well (PW) 352. The N-doped well (NW) 234, the P-doped well (PW) 350, the N-doped well (NW) 240, and the P-doped well (PW) 352 are at least partially formed on top of and in contact with a P-type substrate layer 354, which can be an epitaxial film, an epitaxial layer, or any other suitable substrate. The P-doped region 232 may be the emitter (E) of the PNP bipolar transistor 106 depicted in Fig. 1. The polysilicon (poly) gate 246, which may be the gate terminal (G) of the NMOS transistor 112 depicted in Fig. 1, is formed on top of the P-doped well (PW) 352. In some embodiments, a contact pad (e.g., a metal layer) is formed on the poly gate. In the X-X' cross sectional view, the N-doped region 228 is connected to the VDD pin 230, the P-doped regions 232, 238 and the N-doped region 244 are connected to the Input/Output (I/O) pin 210, and the P-doped region 236, the N-doped region 242, and the poly gate are connected to the VSS pin 220. In some embodiments, a contact layer (e.g., a metal layer) is formed on each of the N-doped regions 228, 242, 244, the P-doped regions 232, 236, 238, and the poly gate. In some embodiments, the P-doped region 238, the N-doped well (NW) 240, and the P-doped well (PW) 352 form a PNP bipolar transistor. In some other embodiments, the P-doped region 238, the N-doped well (NW) 240, and the P-doped well (PW) 350 form a PNP bipolar transistor. In some embodiments, the N-doped region 242, the P-doped well (PW) 352, and the N-doped region 244 form an NMOS transistor or a parasitic PNP bipolar transistor. In some embodiments, the N-doped well (NW) 240, the P-doped well (PW) 352, and the N-doped region 242 form an NPN bipolar transistor. In some embodiments, the N-doped well (NW) 234, the P-doped region 232, and the N-doped region 228 form a diode.

In an example operation of the ESD protection device 204 depicted in Figs. 2 and 3, during an ESD event (e.g., an ESD pulse received between the I/O pin 210 and the VSS pin 220), if the ESD voltage exceeds the trigger voltage of the ESD protection device, an integrated diode is forward biased and current flows through a current path 356 as illustrated in Fig. 3 and referred as the trigger path. Once the integrated diode is forward biased, an integrated SCR is activated and current flows through a current path 358 as illustrated in Fig. 3 and referred as the SCR path. For example, when the voltage at the P-doped region 236 is higher than a threshold voltage (e.g., the sum of the voltage at the VDD pin 230 and the voltage at the integrated diode), hole currents are generated from the integrated diode and diffused to lift-up the P-doped well (PW) 350. Consequently, an parasitic NPN bipolar transistor formed by the N-doped region 242, the P-doped well (PW) 352, and the N-doped region 244 is turned on (i.e., conducting). When the voltage at the P-doped region 238 is higher than a threshold voltage (e.g., the sum of the voltage at the VDD pin and the voltage at the integrated diode) to breakdown the reverse junction between the N-doped well (NW) 240 and the P-doped well (PW) 350/the P-doped region 236, a PNP bipolar transistor formed by the P-doped region 238, the N-doped well (NW) 240, and the P-doped well (PW) 352 is turned on (i.e., conducting), which activates the integrated SCR.

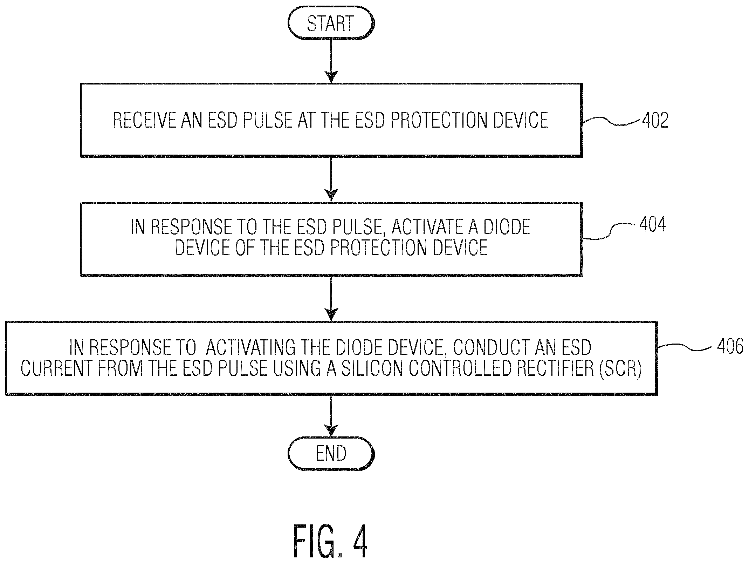

Fig. 4 is a process flow diagram that illustrates a method for operating an ESD protection device in accordance with an embodiment of the invention. At block 402, an ESD pulse is received at the ESD protection device. At block 404, in response to the ESD pulse, a diode device of the ESD protection device is activated. At block 406, in response to activating the diode device, an ESD current is conducted from the ESD pulse using a silicon controlled rectifier (SCR). The ESD protection device may be the same as or similar to the ESD protection device 104 depicted in Fig. 1 and/or the ESD protection device 204 depicted in Fig. 2.
Embodiments of an ESD protection device and a method for operating an ESD protection device are described. In one embodiment, an ESD protection device includes a first bipolar device connected to a first node, a second bipolar device connected to the first bipolar device and to a second node, a metal-oxide-semiconductor (MOS) device connected to the first and second nodes and to the first and second bipolar devices and configured to shunt current in response to an ESD pulse received between the first and second nodes, and a diode device connected to the first node, to a third node, to the first and second bipolar devices, and to the MOS device. Other embodiments are also described.

Although the operations of the method herein are shown and described in a particular order, the order of the operations of the method may be altered so that certain operations may be performed in an inverse order or so that certain operations may be performed, at least in part, concurrently with other operations. In another embodiment, instructions or sub-operations of distinct operations may be implemented in an intermittent and/or alternating manner.

In addition, although specific embodiments of the invention that have been described or depicted include several components described or depicted herein, other embodiments of the invention may include fewer or more components to implement less or more features.

Furthermore, although specific embodiments of the invention have been described and depicted, the invention is not to be limited to the specific forms or arrangements of parts so described and depicted. The scope of the invention is to be defined by the claims appended hereto and their equivalents.

## Claims

1. An electrostatic discharge (ESD) protection device, the ESD protection device comprising:
a first bipolar device connected to a first node;
a second bipolar device connected to the first bipolar device and to a second node;
a metal-oxide-semiconductor (MOS) device connected to the first and second nodes and to the first and second bipolar devices and configured to shunt current in response to an ESD pulse received between the first and second nodes; and
a diode device connected to the first node, to a third node, to the first and second bipolar devices, and to the MOS device.

2. The ESD protection device of claim 1, wherein the first and second bipolar devices are of different types.

3. The ESD protection device of claim 1 or 2, wherein the first bipolar device comprises a PNP bipolar transistor, wherein the second bipolar device comprises an NPN bipolar transistor, and wherein the MOS device comprises an NMOS transistor.

4. The ESD protection device of claim 3, wherein the NMOS transistor comprises:
a gate terminal and a source terminal that are connected to the NPN bipolar transistor and to the second node;
a drain terminal that is connected to an emitter and a base of the PNP bipolar transistor, to the diode device, and to the first node; and
a body that is connected to the PNP bipolar transistor and to the NPN bipolar transistor.

5. The ESD protection device of claim 3 or 4, wherein the gate terminal and the source terminal of the NMOS transistor are connected to an emitter of the NPN bipolar transistor.

6. The ESD protection device of any of claims 3 to 5, wherein the base of the PNP bipolar transistor is connected to a collector of the NPN bipolar transistor.

7. The ESD protection device of any of claims 3 to 6, wherein the body of the NMOS transistor is connected to a collector of the PNP bipolar transistor and to a base of the NPN bipolar transistor.

8. The ESD protection device of any of claims 3 to 7, further comprising a resistor device connected between the NMOS transistor and the second node, where the body of the NMOS transistor is connected to the resistor device.

9. The ESD protection device of any preceding claim, wherein an anode of the diode device is connected to the first node, and wherein a cathode of the diode device is connected to the third node.

10. The ESD protection device of any preceding claim, wherein the MOS device comprises a gate terminal and a source terminal connected to the second node and a body connected to the first and second bipolar devices.

11. The ESD protection device of any preceding claim, wherein the MOS device and at least one of the first and second bipolar devices act as a silicon controlled rectifier (SCR) in response to the ESD pulse.

12. A method for operating an electrostatic discharge (ESD) protection device, the method comprising:
receiving an ESD pulse at the ESD protection device;
in response to the ESD pulse, activating a diode device of the ESD protection device; and
in response to activating the diode device, conducting an ESD current from the ESD pulse using a silicon controlled rectifier (SCR).

13. The method of claim 12, wherein a metal-oxide-semiconductor (MOS) device and a bipolar device of the ESD protection device act as the SCR in response to the ESD pulse.
